# EUROPEAN PATENT APPLICATION

(11) **EP 4 625 688 A1**
(43) Date of publication of application: **01.10.2025**
(21) Application number: 25151680.3
(22) Date of filing: 14.01.2025
(51) Int. Cl.: H01P 3/12, H01P 3/123, H01P 3/20, H01Q 13/02, H01Q 19/30

(54) **ANTENNA STRUCTURES IN GLASS CORES**

(30) Priority: 28.03.2024 US 202418620704
(71) Applicant: Intel Corporation, Santa Clara, CA 95054 (US)
(72) Inventor: ACIKALIN, Tolga, San Jose, 95118 (US); Yang, Tae Young, Portland, 97229 (US); IBRAHIM, Tarek A., Mesa, 85203 (US); GAMBA, Jason M., Gilbert, 85298 (US); YAMADA, Shuhei, Vancouver, 98684 (US)
(74) Representative: Goddar, Heinz J.

(57) **Abstract**

An embodiment may include an apparatus comprising: a substrate, wherein the substrate is an amorphous glass layer; an hole into the substrate; and a structure in the hole, wherein the structure comprises: a first portion comprising a first material composition; and a second portion comprising a second material composition, wherein the first portion and the second portion are vertically stacked within the hole.

## Description

### BACKGROUND

Electronic packaging solutions often rely on wired electrical interconnects in order to communicatively couple components together. For example, wired electrical interconnects may include copper traces, vias, pads, and/or the like. However, as devices continue to scale to smaller feature sizes and routing complexity increases, the processes for designing and fabricating wired electrical interconnects within a package substrate become more complex. Additionally, bandwidth limitations and increasing pin counts have led to difficulty in providing electrical routing within a package substrate.

Accordingly, some solutions for wireless coupling within a package substrate have been proposed. Particularly, radio frequency (RF) coupling between components have been suggested as a solution to enable higher data transmission rates and reduce routing complexity (especially in the case of three-dimensional (3D) heterogeneous integration). RF coupling can be implemented through the use of RF antenna structures, RF filtering structures, guided-wave structures (e.g., parallel-plate waveguide, dielectric waveguide, substrate integrated waveguide), and/or passive RF structures (e.g., power splitter/combiner, phase shifter, impedance load (R/L/C), or attenuator). However, the fabrication of such devices relies on having precise control of the dimensions of antenna structures. Currently, this ability is limited to applications within the buildup layers. Unfortunately, fabricating such RF components within the buildup layers can lead to significant warpage challenges, especially in high volume manufacturing (HVM) process flows.

### BRIEF DESCRIPTION OF THE DRAWINGS

Figure 1 is a cross-sectional illustration of a package substrate with an organic core that comprises integrated vias, in accordance with an embodiment.
Figure 2A is a cross-sectional illustration of a glass core with radio frequency (RF) structures embedded within the core, where the RF structures have heights that are smaller than a thickness of the core, in accordance with an embodiment.
Figure 2B is a cross-sectional illustration of a glass core with RF structures that have no-uniform depths into the core, in accordance with an embodiment.
Figure 2C is a cross-sectional illustration of a glass core with RF structures that comprise electrically conductive regions that are electrically floating with dielectric plugs added in a vertically stacked configuration over the electrically conductive regions, in accordance with an embodiment.
Figure 2D is a cross-sectional illustration of a glass core with dielectric RF structures, in accordance with an embodiment.
Figure 2E is a cross-sectional illustration of a glass core with RF structures that comprise vertically stacked electrically conductive regions separated by dielectric regions, in accordance with an embodiment.
Figure 3A is a cross-sectional illustration of a glass core with a series of RF structures in a row with decreasing depths, in accordance with an embodiment.
Figure 3B is a cross-sectional illustration of a glass core with a first series of RF structures with opposing electrically conductive regions each with a dielectric region between the opposing electrically conductive regions, and a second series of RF structures with floating electrically conductive regions with decreasing heights, in accordance with an embodiment.
Figure 4 is a cross-sectional illustration of a multi-layer glass core with RF structures with depths that are different than a total thickness of the glass core or a thickness of a sub-layer of the glass core, in accordance with an embodiment.
Figure 5 is a cross-sectional illustration of a glass core with a first RF structure that is wirelessly communicatively coupled to an external component and second RF structures that are wirelessly communicatively coupled to each other, in accordance with an embodiment.
Figures 6A - 6C are plan view illustrations of glass cores with RF structures arranged in various antenna configurations, in accordance with an embodiment.
Figure 7 is a perspective view illustration of a glass module that comprises RF structures, in accordance with an embodiment.
Figures 8A - 8L are cross-sectional illustrations that depict a process for fabricating various RF structures within a glass core, in accordance with an embodiment.
Figure 9 is a process flow diagram of a process for fabricating an RF structure within a glass core, in accordance with an embodiment.
Figure 10 is a cross-sectional illustration of an electronic system that comprises a glass core with integrated RF structures, in accordance with an embodiment.
Figure 11 is a schematic of a computing device built in accordance with an embodiment.

### DETAILED DESCRIPTION

Described herein are electronic systems, and more particularly, antenna structures fabricated in glass cores with heights that are different than thickness of the glass cores, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

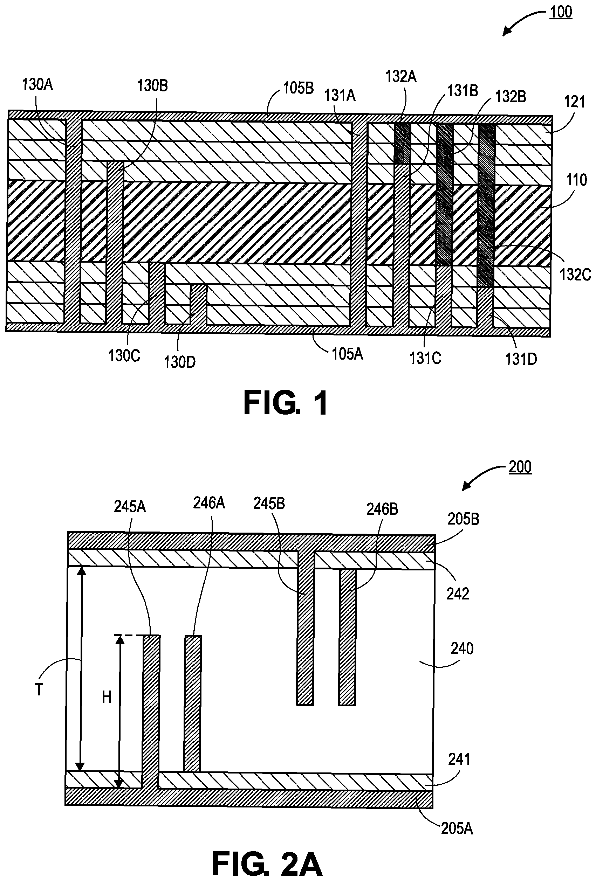

As noted above, radio frequency (RF) structures provide a wireless coupling solution in order to overcome limitations inherent in the electrical routing that is presently used in most electronic packaging solutions. For example, RF structures may enable improved data transmission rates for communication links and improved integration for three-dimensional (3D) heterogeneous integration. RF structures may also reduce routing complexity. In existing solutions, these RF structures are limited to inclusion in the buildup layers of the package substrate. An example of such a solution is shown in Figure 1.

Referring now to Figure 1, a cross-sectional illustration of a package substrate 100 is shown. The package substrate 100 may include an organic core 110. For example, organic dielectric materials (which may include glass fiber reinforcement or the like) are provided between dielectric buildup layers 121. An electrically conductive layer 105A may be provided below the bottom buildup layers 121 (below the core 110), and an electrically conductive layer 105B may be provided over the top buildup layers 121 (above the core 110). A first series of RF structure 130A - 130D are formed on the left side of the package substrate 100, and a second series of RF structures 131A - 131D are formed on the right side of the package substrate 100. For RF structures that pass through the core 110, the heights of the RF structures 130 and the RF structures 131 are equal to a thickness of the core plus an integer multiple of the thickness of an individual buildup layer 121. For RF structures that end before the core 110, the heights of the RF structures 130 and the RF structures 131 are integer multiples of the thickness of an individual buildup layer 121. The RF structures 131 may also include a dielectric plug 132A - 132C above the RF structures 131B - 131D.

As can be appreciated, such a configuration requires set dimensions for the RF structures 130 and 131. This can limit the design of the RF systems. Accordingly, low Q antennas are not always able to be fabricated. Additionally, the integration of RF structures 130 and 131 within the buildup layers 121 can lead to significant warpage issues within the package substrate 100.

Accordingly, embodiments disclosed herein move the formation of the RF structures from the buildup layers into the core. Particularly, a glass core is provided instead of an organic core. The use of a glass core may allow for improvements in the performance of RF systems due to improved electrical and mechanical properties. However, the move to glass core solutions is not without challenges. For example, through glass vias in glass cores are limited to the height of the glass core. As such, multiple glass cores may need to be stacked in order to provide certain RF antenna dimensions. Further, it is difficult and expensive to form thin glass layers (e.g., less than approximately 200µm). Therefore, the minimum step size in the height of the RF structures is around 200µm (e.g., 200µm, 400µm, 600µm, etc.). The number of glass layers that can be stacked reliably is also limited.

In the case of RF structures (e.g., antennas), the optimal via height with a low quality factor Q (or larger operational frequency bandwidth) is often found as a quarter guided-wavelength for single-ended antenna structures and a half guided-wavelength for balanced antenna structures. For example, optimal via height to form a single-ended antenna structure for a 140GHz center frequency in a glass core with a dielectric constant of 5 would be 240µm. Fitting the 140GHz antenna in a 200µm glass layer would therefore result in a higher quality factor Q (or narrower operational frequency bandwidth) as well as having a higher insertion loss.

Accordingly, embodiments disclosed herein include processes for forming RF structures within a glass core that have heights that are different than the thickness of the glass core. This allows for the RF structures to be tailored for a specific center frequency, while also having a large bandwidth (due to a lower quality factor Q). As such, a higher data transmission rate may be possible. Embodiments may also include RF structures that include one or more dielectric plugs in a vertical alignment with the electrically conductive portion. This allows for tailoring of the dielectric constant around the RF structure in order to further refine the wireless performance of the system.

In an embodiment, the RF structures embedded in a glass core may serve as building blocks for the generation of RF systems within a package substrate. For example, RF structures may be assembled into an RF system that comprises a certain RF antenna configuration, a certain RF filtering configuration, guided-wave structures (e.g., parallel-plate waveguide, dielectric waveguide, substrate integrated waveguide), and/or passive RF structures (e.g., power splitter/combiner, phase shifter, impedance load (R/L/C), or attenuator). For example, blind vias that are dielectric materials with a controlled impedance and/or loss can be used to enable impedance load and/or attenuator passive RF structures. In some embodiments, the RF systems may be fabricated as a glass module that may be integrated at any position within a package substrate (e.g., outside of the core). Further, the integration of RF structures within the glass core reduces issues with warpage that may be faced when integrating the RF structures within the buildup layers of the package substrate.

Referring now to Figures 2A - 2E, a series of cross-sectional illustrations depicting portions of a package substrate 200 is shown, in accordance with various embodiments. In the illustrated embodiments, the overlying and underlying buildup layers are omitted for simplicity, in order to highlight the design of various RF structures that are at least partially embedded within a glass core 240.

In an embodiment, the glass cores 240 described herein may be substantially all glass. The glass core 240 may be a solid mass comprising a glass material with an amorphous crystal structure where the solid glass core may also include various structures - such as vias, cavities, channels, or other features - that are filled with one or more other materials (e.g., metals, metal alloys, dielectric materials, etc.). As such, glass core 240 may be distinguished from, for example, the "prepreg" or "FR4" core of a Printed Circuit Board (PCB) substrate which typically comprises glass fibers embedded in a resinous organic material, such as an epoxy.

The glass core 240 may have any suitable dimensions. In a particular embodiment, the glass core 240 may have a thickness that is approximately 50µm or greater. For example, the thickness of the glass core 240 may be between approximately 50µm and approximately 1.4mm. Though, smaller or larger thicknesses may also be used. The glass core 240 may have edge dimensions (e.g., length, width, etc.) that are approximately 10mm or greater. For example, edge dimensions may be between approximately 10mm to approximately 250mm. Though, larger or smaller edge dimensions may also be used. More generally, the area dimensions of the glass core 240 (from an overhead plan view) may be between approximately 10mm x 10mm and approximately 250mm x 250mm. In an embodiment, the glass core 240 may have a first side that is perpendicular or orthogonal to a second side. In a more general embodiment, the glass core 240 may comprise a rectangular prism volume with sections (e.g., vias) removed and filled with other materials (e.g., metal, dielectric, etc.).

The glass core 240 may comprise a single monolithic layer of glass. In other embodiments, the glass core 240 may comprise two or more discrete layers of glass that are stacked over each other. The discrete layers of glass may be provided in direct contact with each other, or the discrete layers of glass may be mechanically coupled to each other by an adhesive or the like. The discrete layers of glass in the glass core 240 may each have a thickness less than approximately 50µm. For example, discrete layers of glass in the glass core 240 may have thicknesses between approximately 25µm and approximately 50µm. Though, discrete layers of glass may have larger or smaller thicknesses in some embodiments. As used herein, "approximately" may refer to a range of values within ten percent of the stated value. For example approximately 50µm may refer to a range between 45µm and 55µm.

The glass core 240 may be any suitable glass formulation that has the necessary mechanical robustness and compatibility with semiconductor packaging manufacturing and assembly processes. For example, the glass core 240 may comprise aluminosilicate glass, borosilicate glass, alumino-borosilicate glass, silica, fused silica, or the like. In some embodiments, the glass core 240 may include one or more additives, such as, but not limited to, Al₂O₃, B₂O₃, MgO, CaO, SrO, BaO, SnO₂, Na₂O, KzO, SrO, P₂O₃, ZrO₂, Li₂O, Ti, or Zn. More generally, the glass core 240 may comprise silicon and oxygen, as well as any one or more of aluminum, boron, magnesium, calcium, barium, tin, sodium, potassium, strontium, phosphorus, zirconium, lithium, titanium, or zinc. In an embodiment, the glass core 240 may comprise at least 23 percent silicon (by weight) and at least 26 percent oxygen (by weight). In some embodiments, the glass core 240 may further comprise at least 5 percent aluminum (by weight).

Referring now to Figure 2A, a cross-sectional illustration of a portion of a package substrate 200 is shown, in accordance with an embodiment. In an embodiment, the package substrate 200 may comprise a glass core 240. In an embodiment, the glass core 240 may have a thickness T. The thickness T may be similar to any of the glass core thickness described in greater detail above. In a particular embodiment, the thickness T may be approximately 200µm.

In an embodiment, a first electrically conductive layer 205A (e.g., a copper layer) may be provided below the glass core 240, and a second electrically conductive layer 205B (e.g., a copper layer) may be provided above the glass core 240. The layers 205A and 205B may also be traces, pads, or the like. In an embodiment, a dielectric layer 241 or 242 may be provided between the glass core 240 and the conductive layers 205A and 205B. The dielectric layers 241 and 242 may sometimes be referred to as buffer layers.

In an embodiment, one or more RF structures 245 and/or 246 may be at least partially embedded within the glass core 240. The RF structures 245 and 246 may comprise electrically conductive material (e.g., copper). The RF structures 245 and 246 may sometimes be referred to as vias. The RF structures 245 and 246 may be configured to propagate and/or receive RF signals to/from components (or other RF structures) within the package substrate 200 and/or external to the package substrate 200. That is, the RF structures 245 and 246 may sometimes be considered RF antennas.

In an embodiment, the RF structures 245 may be electrically coupled to either of the conductive layers 205A or 205B. For example, RF structure 245A is electrically coupled to the conductive layer 205A, and the RF structure 245B is electrically coupled to the conductive layer 205B. In an embodiment, RF structures 246 may be electrically floating. That is, the RF structures 246 may not be directly electrically connected to other circuitry within the package substrate 200. The RF structures 245A and 246A may extend up from a bottom surface of the glass core 240, and the RF structures 245B and 246B may extend down from a top surface of the glass core 240.

In an embodiment, the RF structures 245 and 246 may be referred to as "blind" structures. That is, the RF structures 245 and 246 do not pass entirely through a thickness T of the glass core 240. For example, the RF structure 245A has a height H that is less than the thickness T of the glass core 240. Processes for fabricating such blind structures will be described in greater detail below. The ability to form blind structures enables the design of the RF structures 245 and 246 that possess a desired quality factor Q. For example, low quality factor Q RF structures 245 and 246 may be designed in order to provide higher data transmission rates as a result of a wider operational bandwidth.

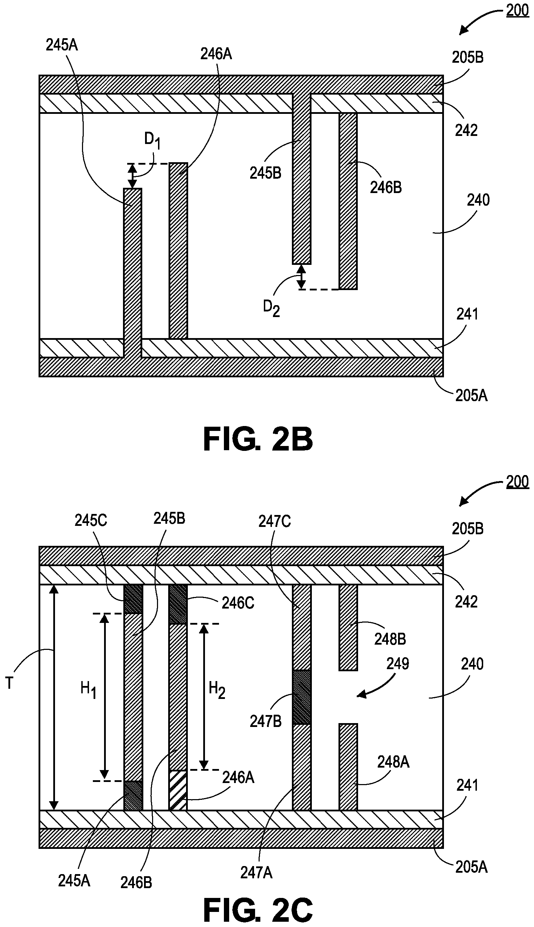

Referring now to Figure 2B, a cross-sectional illustration of a portion of a package substrate 200 is shown, in accordance with an additional embodiment. The package substrate 200 in Figure 2B may be similar to the package substrate 200 in Figure 2A, with the exception of the design of the RF structures 245 and 246. For example, in Figure 2A each pair of RF structures (i.e., a first pair including RF structures 245A and 246A, and a second pair including RF structures 245B and 246B) end at the same depth into the glass core 240. However, in Figure 2B, each pair of RF structures (i.e., a first pair including RF structures 245A and 246A, and a second pair including RF structures 245B and 246B) are formed to different depths within the glass core. The first pair of RF structures 245A/246A have a depth difference D₁, and the second pair of RF structures 245B/246B have a depth difference D₂. The depth differences D₁ and D₂ may be as small as 1µm and as large as the approximate thickness of the glass core 240.

Referring now to Figure 2C, a cross-sectional illustration of a portion of a package substrate 200 is shown, in accordance with an additional embodiment. In an embodiment, the package substrate 200 may differ from those described above with respect to the composition of the RF structures. In Figure 2C, all of the RF structures 245 - 248 are floating structures. However, instead of having a single continuous material throughout an entire height of the RF structures 245 - 248, the RF structures 245 - 248 may have multiple portions (or regions) that are provided in a vertical stack. As used herein, a "vertical stack" may refer to components that are provided over (or under) each other, with centerlines of the stacked components being substantially coincident with each other. "Substantially coincident" may refer to centerlines that are within 10µm of being perfectly coincident with each other.

In a first embodiment of Figure 2C, RF structure 245 may have three portions 245A - 245C. The second portion 245B may be an electrically conductive material (e.g., copper). The second portion 245B may be in a vertical stack between a first portion 245A and a third portion 245C. The first portion 245A and the third portion 245C may comprise dielectric materials. In an embodiment, the dielectric materials of the first portion 245A and the third portion 245C may have a dielectric constant that is different than a dielectric constant of the glass core 240. As such, further tuning of the RF structure 245 can be provided. In other embodiments, the dielectric constant of the third portion 245C may be similar or the same as the dielectric constant of the glass core 240. In an embodiment, a first height Hi of the second portion 245B may be less than a thickness T of the glass core 240. Additionally, the first portion 245A and the third portion 245C are shown with substantially similar heights. Though, in other embodiments, a height of the first portion 245A may be different than a height of the third portion 245C. That is, a distance between a top of the second portion 245B and a top of the glass core 240 may be different than a distance between a bottom of the second portion 245B and a bottom of the glass core 240.

In a second embodiment of Figure 2C, RF structure 246 may also comprise three portions 246A - 246C. However, instead of the first portion 246A and the third portion 246C having the same dielectric material (as shown in RF structure 245), the first portion 246A and the third portion 246C may have different dielectric constants. Additionally, the second portion 246B may have a second height H₂ that is different than the first height Hi of the second portion 245B in the RF structure 245. That is, different RF structures within the same glass core 240 may have second portions 245B/246B that have different heights.

In a third embodiment of Figure 2C, the RF structure 247 also has three portions 247A - 247C. However, RF structure 247 comprises two electrically conductive portions (i.e., first portion 247A and third portion 247C). The first portion 247A may be separated from the third portion 247C by a dielectric second portion 247B. In the illustrated embodiment, the first portion 247A and the third portion 247C have substantially similar heights. Though, in other embodiments a height of the first portion 247A may be different than a height of the third portion 247C.

In a fourth embodiment of Figure 2C, the RF structure 248 may comprise a first portion 248A that is separated from a second portion 248B by a portion 249 of the glass core 240. The first portion 248A and the second portion 248B may both comprise electrically conductive material (e.g., copper). In other embodiments, one or both of the first portion 248A and the second portion 248B may comprise a dielectric material. When both the first portion 248A and the second portion 248B comprise dielectric material, the dielectric materials may be the same or the dielectric materials may be different. Despite not being in direct contact with each other, the first portion 248A and the second portion 248B may still be considered as being vertically stacked, since centerlines of the first portion 248A and the second portion 248B may be substantially coincident with each other. In the illustrated embodiment, the first portion 248A and the second portion 248B have similar heights. Though, in other embodiments, the first portion 248A and the second portion 248B may have different heights.

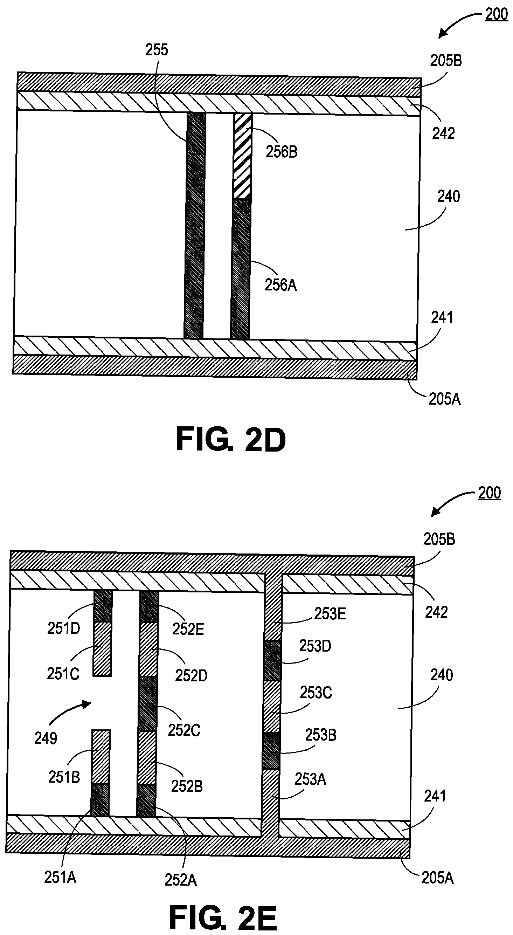

Referring now to Figure 2D, a cross-sectional illustration of a portion of a package substrate 200 is shown, in accordance with an additional embodiment. In an embodiment, a first RF structure 255 comprises a single dielectric material. That is, RF structures described herein do not necessarily require the inclusion of an electrically conductive material. The use of an RF structure that is entirely dielectric (such as RF structure 255) may be suitable for tuning the dielectric constant of a particular region of the glass core 240 in order to improve wireless RF transmission properties (e.g., through improving filtering processes, optimizing directionality of signal propagation, etc.). In an embodiment, a dielectric constant of the RF structure 255 is different than the dielectric constant of the glass core 240. In some embodiments, dielectric RF structure 255 may have a controlled impedance and/or loss which enables the use of the RF structure 255 as an impedance load and/or an attenuator.

In another embodiment, an RF structure 256 may be provided that is entirely dielectric with the inclusion of a first portion 256A and a second portion 256B. The first portion 256A and the second portion 256B may comprise different dielectric materials. In some embodiments, one or both of the first portion 256A and the second portion 256B may have dielectric constants that are different than the dielectric constant of the glass core 240. As shown, the first portion 256A and the second portion 256B have different heights. In other embodiments, the first portion 256A and the second portion 256B may have the same height.

Referring now to Figure 2E, a cross-sectional illustration of a portion of a package substrate 200 is shown, in accordance with yet another embodiment. In an embodiment, the RF structures 251 - 253 may have more than three portions.

In a first embodiment of Figure 2E, an RF structure 251 comprises four portions 251A - 251D. The first portion 251A may be a dielectric material, and the second portion 251B may be an electrically conductive material (e.g., copper). The second portion 251B may be vertically stacked with and directly contacting the first portion 251A. In an embodiment, the third portion 251C may be vertically stacked with the second portion 251B, and the third portion 251C is spaced apart from the second portion 251B by a portion 249 of the glass core 240. The fourth portion 251D may be a dielectric material that is vertically stacked with and directly contacting the third portion 251C. In the illustrated embodiment, the first portion 251A and the second portion 251B are mirror images of the third portion 251C and the fourth portion 251D, respectively. In other embodiments, one or both of the heights of the lower portions 251A and 251B may be different than one or both of the heights of the upper portions 251C and 251D.

In a second embodiment of Figure 2E, an RF structure 252 comprises five portions 252A - 252E. The RF structure 252 may be similar to the RF structure 251, with the exception of the presence of dielectric portion 252C between the lower portions 252A/252B and the upper portions 252D/252E.

In a third embodiment of Figure 2E, an RF structure 253 comprises five portions 253A - 253E. In some instances, the RF structure 253 may be an inverse of RF structure 252. That is, a first portion 253A, a third portion 253C, and a fifth portion 253E may be electrically conductive materials (e.g., copper), while the second portion 253B and the fourth portion 253D may be dielectric materials. In the illustrated embodiment, the first portion 253A is electrically coupled to layer 205A, the fifth portion 253E is electrically coupled to layer 205B, and the third portion 253C is electrically floating. In other embodiments, one or both of the first portion 253A or the fifth portion 253E may be electrically floating.

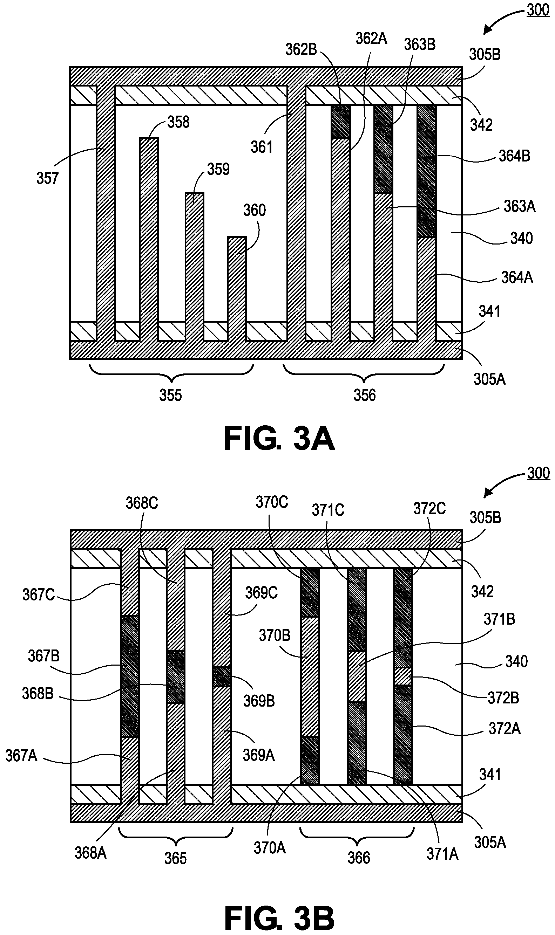

Referring now to Figures 3A and 3B, cross-sectional illustrations of portions of package substrates 300 are shown, in accordance with various embodiments. In the illustrated embodiments, the package substrates 300 comprise glass cores 340 that may be similar to any of the glass cores described in greater detail herein. The package substrates 300 may also comprise electrically conductive layers 305A and 305B over/under the glass core 340. Dielectric layers 341 and 342 may separate the conductive layers 305A and 305B from the glass core 340.

Referring now to Figure 3A a cross-sectional illustration of a portion of a package substrate 300 is shown, in accordance with an embodiment. In an embodiment, the package substrate 300 comprises a first RF system 355 and a second RF system 356. In an embodiment, the first RF system 355 may comprise a plurality of adjacent RF structures 357 - 360. In an embodiment, the RF structures 357 - 360 comprise decreasing heights (from left to right). The RF structure 357 may be electrically coupled to the conductive layers 305A and 305B. That is, a height of the RF structure 357 may be greater than a thickness of the glass core 340. The remaining RF structures 358 - 360 may be blind RF structures with heights that are smaller than the thickness of the glass core 340. In the illustrated embodiment, the RF structures 358 - 360 are all electrically coupled to the conductive layer 305A. Though, one or more of the RF structures 358 - 360 may be electrically floating. While four RF structures 357 - 360 are shown in first RF system 355, it is to be appreciated that any number of RF structures may be included in first RF system 355.

In an embodiment, the second RF system 356 may be similar to the first RF system 355, with the addition of dielectric portions over the RF structures that have heights less than a thickness of the glass core 340. For example, RF structure 361 may be similar to RF structure 357, while RF structures 362 - 364 may each comprise two portions. For example, first portions 362A - 364A may be electrically conductive material (e.g., copper), and overlying second portions 362B - 364B may be dielectric material. In an embodiment, the combined height of both portions in RF structures 362 - 364 may be substantially equal to a thickness of the glass core 340.

Referring now to Figure 3B, a cross-sectional illustration of a portion of a package substrate 300 is shown with a first RF system 365 and a second RF system 366 is shown, in accordance with an embodiment. In the first RF system 365, each RF structure 367 - 369 comprises three portions. The lower portions 367A - 369A and the upper portion 367C - 369C may comprise electrically conductive material (e.g., copper). The middle portions 367B - 369B may comprise dielectric material. In an embodiment, the first RF system 365 may comprise RF structures 367 - 369 where the middle portions 367B - 369B decrease in height. While three RF structures 367 - 369 are shown in the first RF system 365, it is to be appreciated that any number of RF structures may be included in the first RF system 365.

The second RF system 366 may be an inverse of the first RF system 365. That is, the lower portions 370A - 372A and the upper portions 370C - 372C may comprise dielectric material, and the middle portions 370B - 372B may comprise electrically conductive material (e.g., copper). In an embodiment, the second RF system 366 may comprise RF structures 370 - 372 where the middle portions 370B - 372B decrease in height. While three RF structures 370 - 372 are shown in the second RF system 366, it is to be appreciated that any number of RF structures may be included in the second RF system 366.

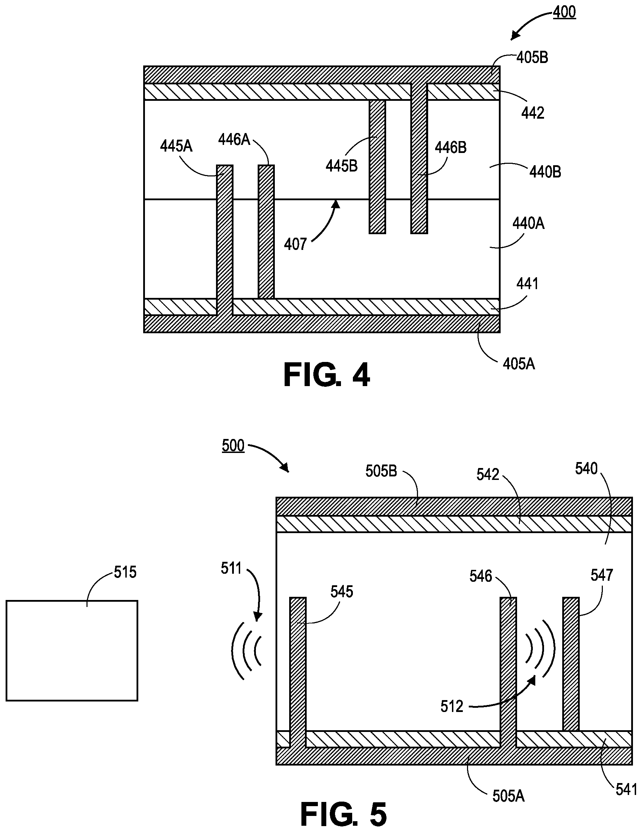

Referring now to Figure 4, a cross-sectional illustration of a portion of a package substrate 400 is shown, in accordance with an additional embodiment. In the illustrated embodiments, the package substrate 400 comprises a multi-layer glass core 440. For example, a first glass layer 440A and a second glass layer 440B may be stacked with an interface 407. The glass layers 440A and 440B may be similar to any of the glass cores described in greater detail herein. The package substrate 400 may also comprise electrically conductive layers 405A and 405B over/under the glass core 440. Dielectric layers 441 and 442 may separate the conductive layers 405A and 405B from the glass core 440.

In an embodiment, the package substrate 400 may comprise any number of RF structures 445 or 446 at least partially embedded within one or both of the first glass layer 440A or the second glass layer 440B. For example, RF structures 445A and 446A may extend up from the bottom of the first glass layer 440A and extend into the second glass layer 440B. In contrast, the RF structures 445B and 446B may extend down from the top of the second glass layer 440B and extend into the first glass layer 440A. Further, while the RF structures 445 and 446 all pass entirely through at least one glass layer 440A or 440B, in some embodiments an RF structure may reside in only one of the glass layers 440A or 440B. Figure 4 shows several examples of RF structures (e.g., RF structures 445A and 445B that are electrically coupled to conductive layers 405A or 405B, and floating RF structures 446A and 446B). Though, it is to be appreciated that any of the RF structures described in greater detail herein can be integrated into a multi-layer glass core.

Referring now to Figure 5, a cross-sectional illustration of a portion of a package substrate 500 that illustrates some RF communicative coupling options is shown, in accordance with an embodiment. In the illustrated embodiments, the package substrates 500 comprise a glass core 540 that may be similar to any of the glass cores described in greater detail herein. The package substrate 500 may also comprise electrically conductive layers 505A and 505B over/under the glass core 540. Dielectric layers 541 and 542 may separate the conductive layers 505A and 505B from the glass core 540.

In an embodiment, a first RF structure 545 is provided proximate to an edge surface of the glass core 540. For example, an edge surface of the first RF structure 545 may be within 100µm of the edge surface of the glass core 540, within 50µm of the edge surface of the glass core 540, within 20µm of the edge surface of the glass core 540, within 5µm of the edge surface of the glass core 540, or within 1µm of the edge surface of the glass core 540. The proximity to the edge surface of the glass core 540 may enable wireless communicative coupling (indicated by waves 511) with a component 515 that is external to the package substrate 500. For example, the component 515 may be a separate package substrate (that may be on the same board as package substrate 500 or external to the board of package substrate 500). In an embodiment, the component 515 may also be a die, a board component, or any other device.

While the component 515 is shown as being external to the package substrate 500, other embodiments may include a component 515 that is integrated as part of the package substrate 500. For example, the component 515 may be embedded within buildup layers (not shown) of the package substrate 500, embedded within the glass core 540, or coupled to a top or bottom surface of the package substrate.

In an embodiment, a second RF structure 546 may be wirelessly communicatively coupled (as indicated by waves 512) to a third RF structure 547. In the illustrated embodiment the second RF structure 546 and the third RF structure 547 are immediately adjacent to each other. Though, in other embodiments, the second RF structure 546 and the third RF structure 547 may be spaced apart. In some instances, one or more other structures (e.g., vias, RF structures, etc.) may be provided in a path between the second RF structure 546 and the third RF structure 547. In some embodiments, the second RF structure 546 and the third RF structure 547 may be different portions of a single RF antenna, such as an RF patch antenna.

The use of wireless communicative coupling provided by RF structures of Figure 5 allows for a reduction in routing complexity within the package substrate 500. Further, low quality factor Q RF structures can be used in order to improve data transmission rates between locations on the package substrate 500 (or between the package substrate 500 and an external component 515) compared to the use of wired (e.g., copper) interconnects.

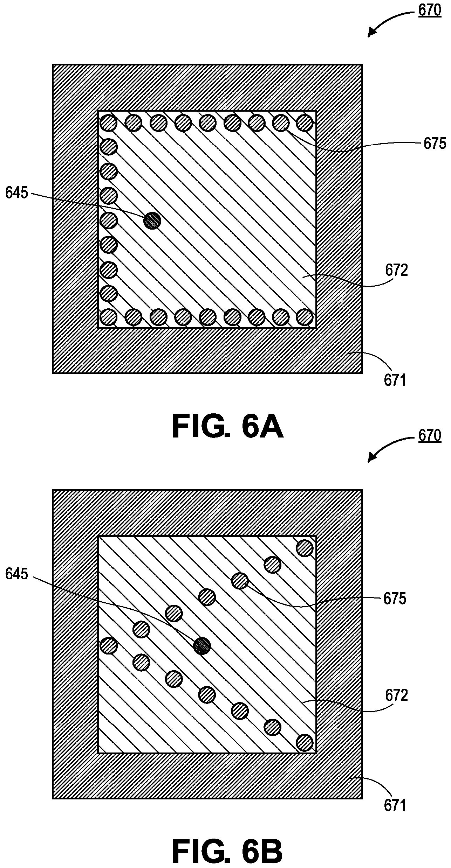

Referring now to Figures 6A - 6C, a series of plan view illustrations depicting RF systems that can be integrated into a glass core is shown, in accordance with an embodiment. In the illustrated embodiments, a bottom ground plane 671 and a top ground plane 672 are shown. A glass core (not shown) that is similar to any of the glass cores described in greater detail herein may be provided between the bottom ground plane 671 and the top ground plane 672.

Referring now to Figure 6A, a plan view illustration of an RF system 670 that is an open-ended waveguide antenna is shown, in accordance with an embodiment. As shown, a plurality of through glass vias (TGVs) 675 may form a U-shape around a driven RF structure 645. The TGVs 675 may be standard TGVs that pass through an entire thickness of the glass core (not shown) and contact both the bottom ground plane 671 and the top ground plane 672. The driven RF structure 645 may be a blind RF structure 645 similar to any of the RF structures described in greater detail herein. For example, the electrically conductive portion of the driven RF structure 645 may have a height that is smaller than a thickness of the glass core. In an embodiment, the driven RF structure 645 may be electrically isolated from the top ground plane 672 (e.g., by an insulator) or by providing a hole through the top ground plane 672 around the driven RF structure 645. The driven RF structure 645 may be electrically coupled to an RF signal source.

Referring now to Figure 6B, a plan view illustration of an RF system 670 that is a corner reflector antenna is shown, in accordance with an embodiment. As shown, a plurality of TGVs 675 may form a V-shape around a driven RF structure 645. The TGVs 675 may be standard TGVs that pass through an entire thickness of the glass core (not shown) and contact both the bottom ground plane 671 and the top ground plane 672. The driven RF structure 645 may be a blind RF structure 645 similar to any of the RF structures described in greater detail herein. For example, the electrically conductive portion of the driven RF structure 645 may have a height that is smaller than a thickness of the glass core. In an embodiment, the driven RF structure 645 may be electrically isolated from the top ground plane 672 (e.g., by an insulator) or by providing a hole through the top ground plane 672 around the driven RF structure 645. The driven RF structure 645 may be electrically coupled to an RF signal source.

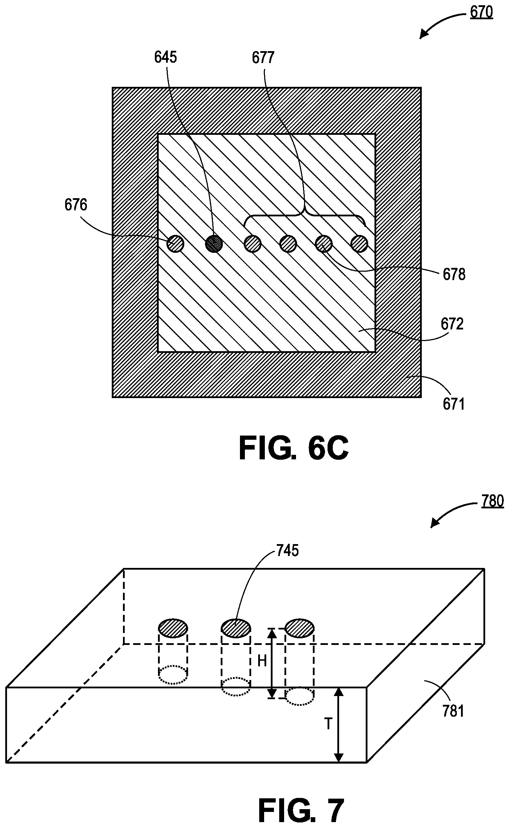

Referring now to Figure 6C, a plan view illustration of an RF system 670 that is a Yagi-Uda antenna is shown, in accordance with an embodiment. As shown, a reflecting TGV 676 may be provided on one side of a driven RF structure 645, and a plurality 677 of directing TGVs 678 are provided on an opposite side of the drive RF structure 645 from the reflecting TGV 676. The reflecting TGV 676 and the directing TGVs 678 may be blind TGVs that only pass partially through an entire thickness of the glass core (not shown). That is the TGVs 676 and 678 may only contact the top ground plane 672. The driven RF structure 645 may also be a blind RF structure 645 similar to any of the RF structures described in greater detail herein. For example, the electrically conductive portion of the driven RF structure 645 may have a height that is smaller than a thickness of the glass core. In an embodiment, the driven RF structure 645 may be electrically isolated from the top ground plane 672 (e.g., by an insulator) or by providing a hole through the top ground plane 672 around the driven RF structure 645. The driven RF structure 645 may be electrically coupled to an RF signal source.

Figures 6A - 6C provide examples of RF antenna systems that are formed with RF structures described herein in accordance with various embodiments. However, it is to be appreciated that many different antenna systems can be fabricated through various combinations and arrangements of RF structures similar to those described herein. Further, while antenna structures for propagating and/or receiving wireless RF signals are shown, it is to be appreciated that RF systems may also include filtering systems. Embodiments may also comprise RF systems that comprise guided-wave structures (e.g., parallel-plate waveguide, dielectric waveguide, substrate integrated waveguide), and/or passive RF structures (e.g., power splitter/combiner, phase shifter, impedance load (R/L/C), or attenuator).

Referring now to Figure 7, a perspective view illustration of a glass module 780 is shown, in accordance with an embodiment. In an embodiment, the glass module 780 may comprise a piece of glass 781 (either a single layer glass piece or a multi-layer glass piece) that has a similar composition to glass cores described in greater detail herein. However, instead of being an entire package substrate core, the glass module 780 may be a smaller component suitable for integration in other portions of a package substrate (not shown). For example, a glass module 780 may be embedded in buildup layers of a package substrate or provided over a package substrate. The glass module 780 may be fabricated in a panel form factor with a process similar to those used for fabricating a glass core (which will be described in greater detail herein). After fabrication, the glass module 780 may be singulated from the panel and used elsewhere.

In an embodiment, one or more RF structures 745 (three are shown as an example in Figure 7) may be embedded in the piece of glass 781. The RF structures 745 may be similar to one or more of the RF structures described in greater detail herein. In an embodiment, the RF structures 745 may comprise an electrically conductive portion with a height H that is less than a thickness T of the piece of glass 781.

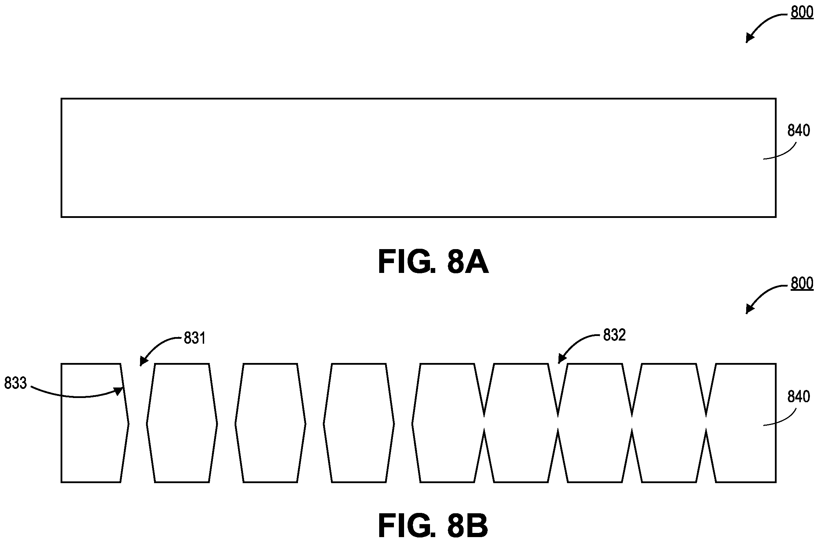

Referring now to Figures 8A - 8L, a series of cross-sectional illustrations depicting a process for forming RF structures similar to one or more of those described in greater detail herein is shown, in accordance with an embodiment. While several specific examples of different RF structures are shown in Figures 8A - 8L, it is to be appreciated that any of the RF structures described herein may be fabricated using similar operations (which may include adding one or more additional patterning loops, eliminating one or more patterning loops, depositing different dielectric materials, changing etching depths for one or more of the patterning loops, etc.).

Referring now to Figure 8A, a cross-sectional illustration of a portion of a package substrate 800 at a stage of manufacture is shown, in accordance with an embodiment. Particularly, an unpatterned glass core 840 is shown. The glass core 840 may be similar to any of the glass cores described in greater detail herein.

Referring now to Figure 8B, a cross-sectional illustration of the portion of the package substrate 800 after a via opening operation is shown, in accordance with an embodiment. In an embodiment, the via openings 831 may pass entirely through a thickness of the glass core 840. The via openings 832 may pass partially through a thickness of the glass core 840. With respect to the via openings 832, each via opening 832 is vertically stacked over a via opening 832 on the other side of the glass core 840. Though, in other embodiments one or more of the via openings 832 may not be vertically stacked. As used herein, via openings 831 and/or via openings 832 may also be referred to as holes.

In the illustrated embodiment, sidewalls 833 of the via openings 831 and 832 may be sloped. For example, via openings 831 may have sidewalls 833 that slope to form an hourglass shaped cross-section, and the via openings 832 may have sidewalls 833 that converge to a point at a bottom of the via openings 832. The sloped profile of the sidewalls 833 may be a characteristic feature of a laser assisted etching process. For example, a laser may be used to modify a microstructure and/or a chemical structure of the glass in the glass core 840. The modified glass regions may be more susceptible to a given etching chemistry used to form the via openings 831 and 832. The depth of the via openings 831 and 832 may be controlled by controlling a dose of laser light at the different locations. Accordingly, via openings 832 with a specific depth into (but not entirely through) the thickness of the glass core 840 can be chosen in order to set desired dimensions of the resulting RF structures. Accordingly, optimization of the RF characteristics (e.g., quality factor, center frequency, etc.) can be enabled for a wide range of RF structures.

While sloped sidewalls 833 are shown in Figures 8A - 8L, substantially vertical sidewalls may also be provided in some embodiments. Additionally, while previous embodiments depict substantially vertical sidewalls, any of the embodiments described herein may be fabricated with via openings that are similar to those shown in Figures 8A - 8L. That is, any RF structure disclosed herein may include sloped sidewalls that form a tapered cross-section (with or without a point) or an hourglass shaped cross-section.

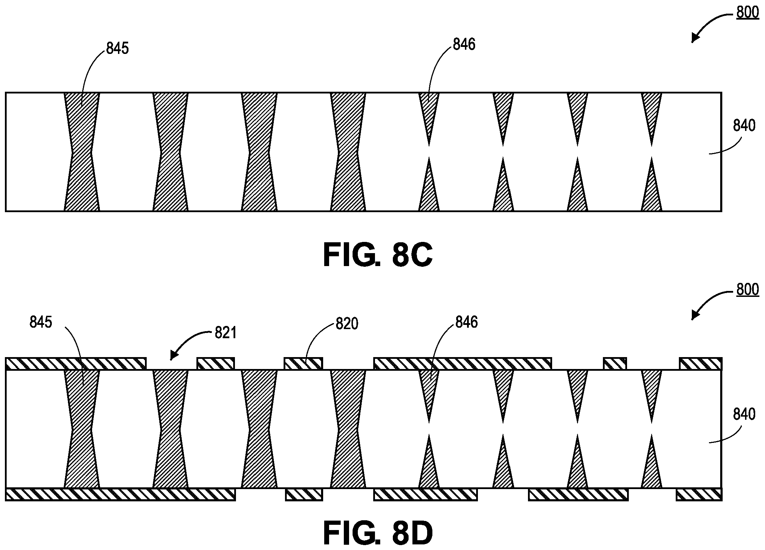

Referring now to Figure 8C, a cross-sectional illustration of the portion of the package substrate 800 after the via openings 831 and 832 are metallized is shown, in accordance with an embodiment. The metallized features may include RF structures 845 (that pass entirely through a thickness of the glass core 840) and RF structures 846 (that pass partially through the thickness of the glass core 840). The metallization process may be a plating process (e.g., electroplating) or any other suitable deposition process (e.g., physical vapor deposition (PVD), chemical vapor deposition (CVD), or the like). Any overburden above or below the glass core 840 may be polished back (e.g., with a chemical mechanical polishing (CMP) process).

Referring now to Figure 8D, a cross-sectional illustration of the portion of the package substrate 800 after a first resist layer 820 is deposited and patterned to form openings 821 is shown, in accordance with an embodiment. As shown, openings 821 may be formed over one or more of the RF structures 845 and/or the RF structures 846. The first resist layer 820 may be provided over both the top and bottom of the glass core 840.

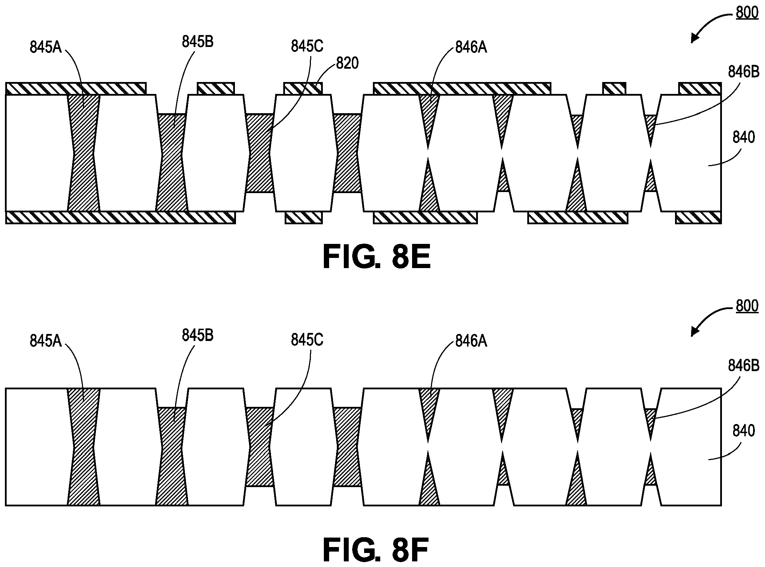

Referring now to Figure 8E, a cross-sectional illustration of the portion of the package substrate 800 after a first etching process is shown, in accordance with an embodiment. The first etching process may recess surfaces of the exposed RF structures 845B, 845C, and 846B. RF structures 845A and 846A may be entirely covered by the resist layer 820 and will not be recessed.

Referring now to Figure 8F, a cross-sectional illustration of the portion of the package substrate 800 after the first resist layer 820 is removed is shown, in accordance with an embodiment. In an embodiment, the first resist layer 820 may be removed with a resist stripping process, or the like.

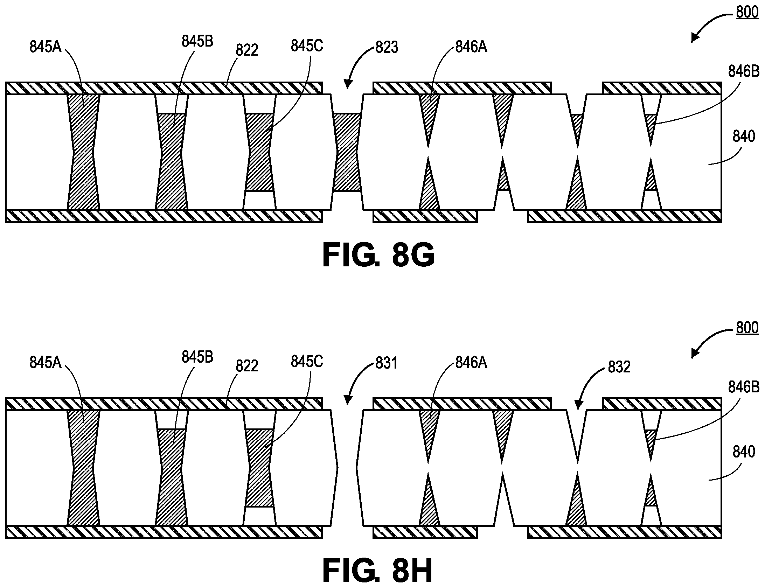

Referring now to Figure 8G, a cross-sectional illustration of the portion of the package substrate 800 after a second resist layer 822 is deposited and patterned to form openings 823 is shown, in accordance with an embodiment. Second resist layers 822 may be provided both above and below the glass core 840 in some embodiments. In an embodiment, the openings 823 may be provided over one or more of the RF structures that were etched previously in Figure 8E. That is, some surfaces that were recessed once may be recessed again. This enables the formation of multiple different height RF structures within the same glass core 840. Alternatively, the RF structures exposed in Figure 8G may be fully removed with subsequent etching processes. While a double etch process is described herein, it is to be appreciated that a single etching loop may be used, or a plurality of etching loops may be used in order to provide RF structures with any number of different heights within a single glass core 840.

Referring now to Figure 8H, a cross-sectional illustration of the portion of package substrate 800 after the second etching process is shown, in accordance with an embodiment. In the illustrated embodiment, the second etching process is a clearing process that completely removes the RF structure from the via openings. For example, one of the via openings 831 and two of the via openings 832 are cleared in Figure 8H.

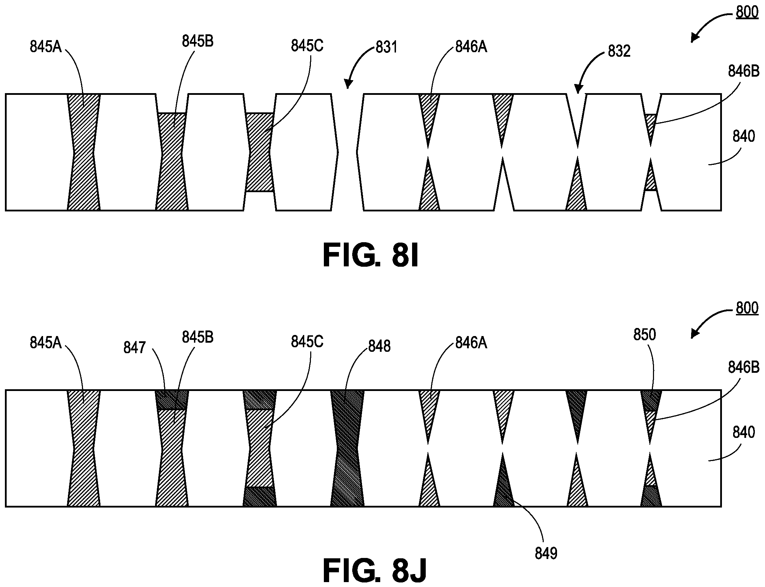

Referring now to Figure 8I, a cross-sectional illustration of the portion of the package substrate 800 after the second resist layer 822 is removed is shown, in accordance with an embodiment. In an embodiment, the second resist layer 822 may be removed with a resist stripping process, or the like.

Referring now to Figure 8J, a cross-sectional illustration of the portion of the package substrate 800 after dielectric plugs 847, 848, 849, and 850 are added into the exposed portions of the via openings is shown, in accordance with an embodiment. For example, a dielectric plug 847 is provided over the top surface of the RF structure 845B, a pair of dielectric plugs 847 are provided above and below the RF structure 845C, a dielectric plug 848 is provided in the completely voided via opening 831, a dielectric plug 849 is provided in each of the completely voided via openings 832, and a dielectric plug 850 is provided over RF structures 846B.

As can be appreciated, since the plugs 847 - 850 and the corresponding RF structures fill in the same via openings, the plug and the RF structure will have substantially coincident centerlines. As such, the plugs and the corresponding RF structures will be considered as being vertically stacked.

The dielectric material for the plugs 847 - 850 may be deposited with a molding process, a lamination process, or any other deposition process. Any overburden may be removed with a CMP process or the like. In the illustrated embodiment, all of the plugs 847 - 850 are the same material. In other embodiments, different dielectric materials may be provided over different RF structures by providing multiple masking and plug deposition process loops.

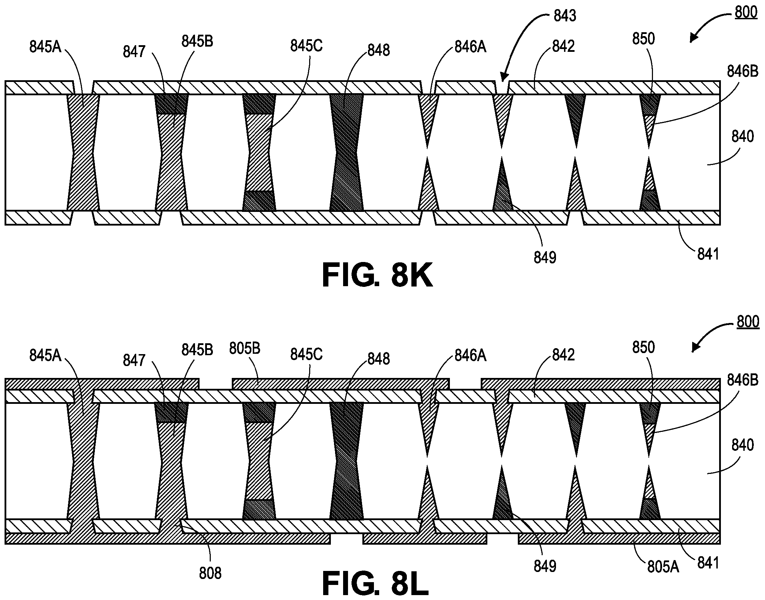

Referring now to Figure 8K, a cross-sectional illustration of the portion of the package substrate 800 after dielectric layers 841 and 842 are provided over the glass core 840 and patterned to form openings 843 is shown, in accordance with an embodiment. For example, the dielectric layers 841 and 842 may be deposited with a lamination process or the like. In an embodiment, the openings 843 may be formed with a laser patterning process, a chemical etching process or the like.

Referring now to Figure 8L, a cross-sectional illustration of the portion of the package substrate 800 after metal layers 805A and 805B are added over the dielectric layers 841 and 842 is shown, in accordance with an embodiment, the deposition of the metal layers 805A and 805B may also fill openings 843 to form vias 808 to provide electrical contact to one or more of the RF structures 845 and/or 846. The metal layers 805A and 805B may also be patterned to provide electrical isolation where necessary.

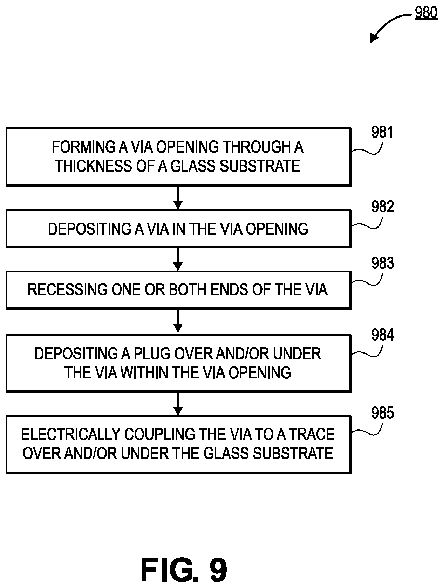

Referring now to Figure 9, a process flow diagram of a process 980 for forming RF structures in a glass core is shown, in accordance with an embodiment. In an embodiment, the process 980 may be modified with one or more operations similar to those described above with respect to Figures 8A - 8L (or elsewhere herein) in order to provide RF structures in accordance with any of those described in greater detail herein.

In an embodiment, the process 980 may begin with operation 981, which comprises forming a via opening through a thickness of a glass substrate. In an embodiment, the via opening may be formed with a laser assisted patterning process.

In an embodiment, the process 980 may continue with operation 982, which comprises depositing a via in the via opening. In an embodiment, the via may be an electrically conductive via that is deposited with any suitable process. The via may be planarized so that surfaces are substantially coplanar with a top and bottom of the glass substrate.

In an embodiment, the process 980 may continue with operation 983, which comprises recessing one or both ends of the via. The recessing may be implemented through the deposition of a resist layer over the top and bottom surfaces of the glass substrate. An opening through the resist layer is then formed over one or both ends of the via that is desired to be recessed. An etchant is then used to selectively recess exposed ends of the via.

In an embodiment, the process 980 may continue with operation 984, which comprises depositing a plug over and/or under the via within the via opening. The plug may be a dielectric material that is provided with any suitable deposition process. In an embodiment with a recessed top and bottom surface, the top plug may be a different dielectric material than the bottom plug.

In an embodiment, the process 980 may continue with operation 985, which may comprise electrically coupling the via to a trace over and/or under the glass substrate. The trace may be separated from the glass substrate by a dielectric layer. In such an embodiment, a via may be provided through the dielectric layer to electrically couple the via to trace. While electrical coupling to a trace is described in operation 985, it is to be appreciated that embodiments may end after operation 984. That is, the recessed and plugged via may be electrically floating.

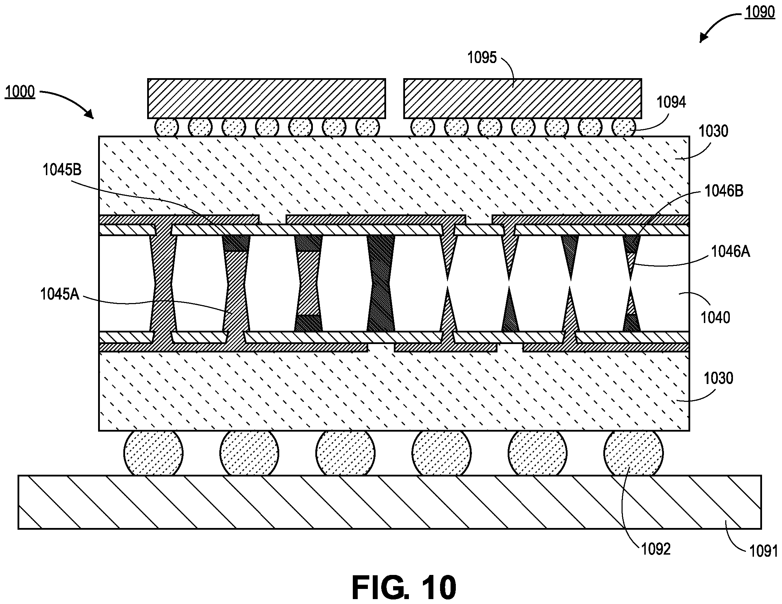

Referring now to Figure 10, a cross-sectional illustration of an electronic system 1090 is shown, in accordance with an embodiment. The electronic system 1090 may comprise a board 1091, such as a printed circuit board (PCB), a motherboard, or the like. The board 1091 may be coupled to a package substrate 1000 through second level interconnects (SLIs) 1092. The SLIs 1092 may comprise solder joints, pins, sockets, or the like.

In an embodiment the package substrate 1000 may be similar to any of the package substrates described in greater detail herein. For example, the package substrate 1000 may comprise a glass core 1040 with buildup layers 1030 over and under the glass core 1040. In an embodiment, the glass core 1040 may comprise any number of RF structures 1045 or 1046 similar to any of the embodiments described in greater detail herein. For example, RF structure 1045 may comprise an electrically conductive first region 1045A with a height less than a thickness of the glass core 1040, and a dielectric plug second region 1045B. The RF structure 1046 may comprise an electrically conductive first region 1046A and a dielectric plug second region 1046B.

In an embodiment, one or more dies 1095 may be electrically coupled to the package substrate 1000 through first level interconnects (FLIs) 1094. The FLIs 1094 may comprise solder bumps, copper bumps, hybrid bonding interfaces, and/or the like. In an embodiment, the dies 1095 may be any type of die, such as a central processing unit (CPU), a graphics processing unit (GPU), an XPU, a communications die, a memory die, or the like.

In an embodiment, the RF structures 1045 and/or 1046 may be used to provide wireless communicative coupling between components within the electronic system 1090. For example, one or more of the RF structures 1045 and/or 1046 may be wirelessly communicatively coupled to one or more of the dies 1095, a different RF structure 1045 and/or 1046, and/or any other component in the electronic system 1090. Further, one or more of the RF structures 1045 and/or 1046 may be wirelessly communicatively coupled to one or more components external to the electronic system 1090.

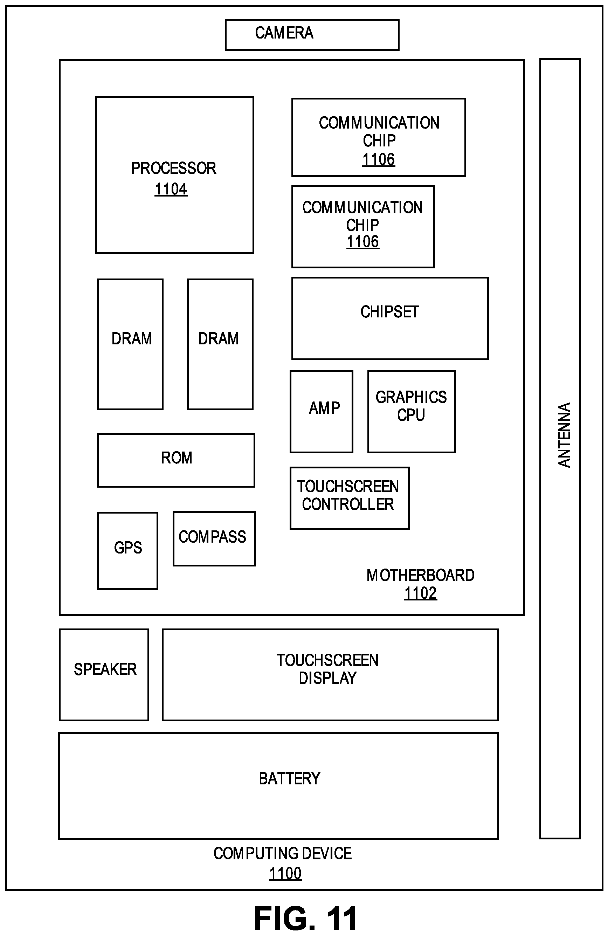

Figure 11 illustrates a computing device 1100 in accordance with one implementation of the disclosure. The computing device 1100 houses a board 1102. The board 1102 may include a number of components, including but not limited to a processor 1104 and at least one communication chip 1106. The processor 1104 is physically and electrically coupled to the board 1102. In some implementations the at least one communication chip 1106 is also physically and electrically coupled to the board 1102. In further implementations, the communication chip 1106 is part of the processor 1104.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1106 enables wireless communications for the transfer of data to and from the computing device 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1106 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1100 may include a plurality of communication chips 1106. For instance, a first communication chip 1106 may be dedicated to shorter range wireless communications such as Wi-Fi and Bluetooth and a second communication chip 1106 may be dedicated to longer range wireless communications such as GPS, EDGE, GPRS, CDMA, WiMAX, LTE, Ev-DO, and others.

The processor 1104 of the computing device 1100 includes an integrated circuit die packaged within the processor 1104. In some implementations of the disclosure, the integrated circuit die of the processor may be part of an electronic package that comprises a glass core with embedded RF structures that have one or more portions with heights that are less than a thickness of the glass core, in accordance with embodiments described herein. The term "processor" may refer to any device or portion of a device that processes electronic data from registers and/or memory to transform that electronic data into other electronic data that may be stored in registers and/or memory.

The communication chip 1106 also includes an integrated circuit die packaged within the communication chip 1106. In accordance with another implementation of the disclosure, the integrated circuit die of the communication chip may be part of an electronic package that comprises a glass core with embedded RF structures that have one or more portions with heights that are less than a thickness of the glass core, in accordance with embodiments described herein.

In an embodiment, the computing device 1100 may be part of any apparatus. For example, the computing device may be part of a personal computer, a server, a mobile device, a tablet, an automobile, or the like. That is, the computing device 1100 is not limited to being used for any particular type of system, and the computing device 1100 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus comprising: a substrate, wherein the substrate is an amorphous glass layer; an hole into the substrate; and a structure in the hole, wherein the structure comprises: a first portion comprising a first material composition; and a second portion comprising a second material composition, wherein the first portion and the second portion are vertically stacked within the hole.

Example 2: the apparatus of Example 1, wherein the first portion has a first height and the second portion has a second height, and wherein the first height is different than the second height.

Example 3: the apparatus of Example 1 or Example 2, wherein the first material composition comprises an electrically conductive material, and the second material composition comprises a dielectric material.

Example 4: the apparatus of Example 3, wherein the substrate has a first dielectric constant and the second material composition has a second dielectric constant, and wherein the first dielectric constant is different than the first dielectric constant.

Example 5: the apparatus of Examples 1-4, wherein the structure further comprises: a third portion, wherein the second portion is between the first portion and the third portion, and wherein the third portion comprises the first material composition.

Example 6: the apparatus of Examples 1-5, wherein the hole passes entirely through a thickness of the substrate.

Example 7: the apparatus of Examples 1-6, wherein a depth of the hole is smaller than a thickness of the substrate.

Example 8: the apparatus of Examples 1-7, further comprising: a second hole into the substrate adjacent to the hole; and a second structure in the second hole, wherein the second structure comprises: a third portion comprising the first material composition; and a fourth portion comprising the second material composition, wherein the third portion and the fourth portion are vertically stacked within the second hole.

Example 9: the apparatus of Example 8, wherein a height of the third portion is different than a height of the first portion.

Example 10: the apparatus of Examples 1-9, wherein the structure is an antenna structure, a filter, a guided-wave structure, and/or a passive RF structure.

Example 11: an apparatus, comprising: a substrate, wherein the substrate is an amorphous glass layer; a first layer over the substrate, wherein the first layer is electrically conductive; a second layer under the substrate, wherein the second layer is electrically conductive; and a radio frequency (RF) system at least partially embedded within the substrate, wherein the RF system comprises: a first via into the substrate, wherein a height of the first via is less than a thickness of the substrate, and wherein the first via is electrically coupled to an RF signal source; and a plurality of second vias into the substrate, wherein the plurality of second vias are each electrically coupled to one or both of the first layer and the second layer.

Example 12: the apparatus of Example 11, wherein the RF system is an antenna.

Example 13: the apparatus of Example 12, wherein the antenna is an open-ended waveguide antenna, a corner reflector antenna, or a Yagi-Uda antenna.

Example 14: the apparatus of Examples 11-13, wherein the RF system is a filter, a guided-wave structure, and/or a passive RF structure.

Example 15: the apparatus of Examples 11-14, wherein the first via is in a hole that passes through an entire thickness of the substrate, wherein a plug fills a portion of the hole, and wherein the plug is a dielectric material.

Example 16: the apparatus of Examples 11-15, wherein the first layer and the second layer are configured to be grounded.

Example 17: the apparatus of Examples 11-16, wherein the first via is within 100µm of an edge of the substrate.

Example 18: the apparatus of Examples 11-17, further comprising: first dielectric layers over the substrate; second dielectric layers under the substrate; a board coupled to the second dielectric layers; and a die coupled to the first dielectric layers.

Example 19: an apparatus, comprising: a substrate, wherein the substrate is a glass layer; a first radio frequency (RF) antenna portion embedded in the substrate, wherein the first RF antenna portion is electrically coupled to an electrically conductive trace over or under the substrate; and a second RF antenna portion embedded in the substrate, wherein the second RF antenna portion is electrically floating, and wherein the first RF antenna portion is configured to be communicatively coupled to the second RF antenna portion.

Example 20: the apparatus of Example 19, wherein the first RF antenna portion comprises an electrically conductive via portion and a dielectric plug portion over the electrically conductive via portion.

## Claims

1. An apparatus comprising:
a substrate, wherein the substrate is an amorphous glass layer;
a hole into the substrate; and
a structure in the hole, wherein the structure comprises:
a first portion comprising a first material composition; and
a second portion comprising a second material composition, wherein the first portion and the second portion are vertically stacked within the hole.

2. The apparatus of claim 1, wherein the first portion has a first height and the second portion has a second height, and wherein the first height is different than the second height.

3. The apparatus of claim 1 or 2, wherein the first material composition comprises an electrically conductive material, and the second material composition comprises a dielectric material.

4. The apparatus of claim 3, wherein the substrate has a first dielectric constant and the second material composition has a second dielectric constant, and wherein the first dielectric constant is different than the first dielectric constant.

5. The apparatus of claim 1, 2, 3 or 4, wherein the structure further comprises:
a third portion, wherein the second portion is between the first portion and the third portion, and wherein the third portion comprises the first material composition.

6. The apparatus of claim 1, 2, 3, 4 or 5, wherein the hole passes entirely through a thickness of the substrate.

7. The apparatus of claim 1, 2, 3, 4, 5 or 6, wherein a depth of the hole is smaller than a thickness of the substrate.

8. The apparatus of claim 1, 2, 3, 4, 5, 6 or 7, further comprising:
a second hole into the substrate adjacent to the hole; and
a second structure in the second hole, wherein the second structure comprises:
a third portion comprising the first material composition; and
a fourth portion comprising the second material composition, wherein the third portion and the fourth portion are vertically stacked within the second hole.

9. The apparatus of claim 8, wherein a height of the third portion is different than a height of the first portion.

10. The apparatus of claim 1, 2, 3, 4, 5, 6, 7, 8 or 9, wherein the structure is an antenna structure, a filter, a guided-wave structure, and/or a passive RF structure.

11. A method of fabricating an apparatus, the method comprising:
forming a substrate, wherein the substrate is an amorphous glass layer;
forming a hole into the substrate; and
forming a structure in the hole, wherein forming the structure comprises:
forming a first portion comprising a first material composition; and
forming a second portion comprising a second material composition, wherein the first portion and the second portion are vertically stacked within the hole.

12. The method of claim 11, wherein the first portion has a first height and the second portion has a second height, and wherein the first height is different than the second height.

13. The method of claim 11 or 12, wherein the first material composition comprises an electrically conductive material, and the second material composition comprises a dielectric material.

14. The method of claim 13, wherein the substrate has a first dielectric constant and the second material composition has a second dielectric constant, and wherein the first dielectric constant is different than the first dielectric constant.

15. The method of claim method of claim 11, 12, 13 or 14, wherein forming the structure further comprises:
forming a third portion, wherein the second portion is between the first portion and the third portion, and wherein the third portion comprises the first material composition.
